# EUROPEAN PATENT APPLICATION

(11) **EP 4 293 708 A1**
(43) Date of publication of application: **20.12.2023**
(21) Application number: 23174318.8
(22) Date of filing: 19.05.2023
(51) Int. Cl.: H01L 21/56, H01L 23/00, H01L 23/31, H01L 25/18

(54) **ELECTRONIC DEVICE AND MANUFACTURING METHOD THEREOF**

(30) Priority: 15.06.2022 US 202263352233 P; 13.03.2023 CN 202310235423
(71) Applicant: InnoLux Corporation, Jhunan Town Miao li 35053 (TW)
(72) Inventor: WANG, Cheng-Chi, 35053 Jhunan Town, Miaoli County (TW); YUEH, Jui-Jen, 35053 Jhunan Town, Miaoli County (TW); LEE, Kuan-Feng, 35053 Jhunan Town, Miaoli County (TW)
(74) Representative: Becker, Eberhard

(57) **Abstract**

An electronic device (1) including a chip (10), an element structure layer (11), a redistribution structure layer (12) and a protective layer (13) is provided. The chip (10) has an active surface (S10A) and a plurality of contacts (100) disposed on the active surface (S10A). The element structure layer (11) is disposed adjacent to the active surface (S10A) and has a switch element (SW). The switch element (SW) is electrically connected to the chip (10) through at least one of the plurality of contacts (100). The redistribution structure layer (12) is disposed adjacent to the active surface (S10A) and is electrically connected to the chip (10) through at least one of the plurality of contacts (100). The protective layer (13) includes a first portion (130) and a second portion (131). The first portion (130) surrounds the chip (10), and the second portion (131) surrounds the element structure layer (11) and the redistribution structure layer (12). A manufacturing method of an electronic device (1) is also provided.

## Description

### Background

### Technical Field

The disclosure relates to an electronic device and a manufacturing method thereof.

### Description of Related Art

Factors such as functionality and reliability of electronic devices affect the market competitiveness of electronic devices. Therefore, how to integrate different elements to realize different functions or improve reliability has become an important issue.

### Summary

An electronic device and a manufacturing method thereof are provided in the disclosure, which facilitates integrating different elements or improving reliability.

In an embodiment of the disclosure, an electronic device includes a chip, an element structure layer, a redistribution structure layer, and a protective layer. The chip has an active surface and multiple contacts disposed on the active surface. The element structure layer is disposed adjacent to the active surface and has a switch element. The switch element is electrically connected to the chip through at least one of the contacts. The redistribution structure layer is disposed adjacent to the active surface and is electrically connected to the chip through at least one of the contacts. The protective layer includes a first portion and a second portion. The first portion surrounds the chip, and the second portion surrounds the element structure layer and the redistribution structure layer.

In an embodiment of the disclosure, the manufacturing method for an electronic device includes the following operation. An element structure layer and a redistribution structure layer are formed on a carrier, in which the element structure layer has a switch element. A chip is disposed on the carrier. The chip has an active surface and multiple contacts disposed on the active surface, and the contacts are electrically connected to the switch element and the redistribution structure layer. A protective layer is formed on the carrier, and the protective layer includes a first portion and a second portion. The first portion surrounds the chip, and the second portion surrounds the element structure layer and the redistribution structure layer.

In order to make the above-mentioned features and advantages of the disclosure comprehensible, embodiments accompanied with drawings are described in detail below.

### BRIEF DESCRIPTION OF THE DRAWINGS

FIG. 1 is a cross-sectional schematic view of an electronic device according to a first embodiment of the disclosure.
FIG. 2 is an enlarged view of region R in FIG. 1.
FIG. 3A to FIG. 3F are cross-sectional schematic views of the manufacturing process of the electronic device of the first embodiment.
FIG. 4 is a cross-sectional schematic view of an electronic device according to a second embodiment of the disclosure.
FIG. 5A to FIG. 5E are cross-sectional schematic views of the manufacturing process of the electronic device of the second embodiment.
FIG. 6 is a top schematic view of an electronic device according to a third embodiment of the disclosure.
FIG. 7 and FIG. 8 are respectively a top schematic view and a cross-sectional schematic view of an electronic device according to a fourth embodiment of the disclosure.

### DETAILED DESCRIPTION OF DISCLOSED EMBODIMENTS

References of the exemplary embodiments of the disclosure are to be made in detail. Examples of the exemplary embodiments are illustrated in the drawings. If applicable, the same reference numerals in the drawings and the descriptions indicate the same or similar parts.

Certain terms may be used throughout the disclosure and the appended patent claims to refer to specific elements. It should be understood by those of ordinary skill in the art that electronic device manufacturers may refer to the same element by different names. The disclosure does not intend to distinguish between elements that have the same function but have different names. In the following description and patent claims, words such as "comprising" and "including" are open-ended words, so they should be interpreted as meaning "including but not limited to...".

In the disclosure, wordings used to indicate directions, such as "up," "down," "front," "back," "left," and "right," merely refer to directions in the accompanying drawings. Therefore, the directional wordings are used to illustrate rather than limit the disclosure. In the accompanying drawings, the drawings illustrate the general features of the methods, structures, and/or materials used in the particular embodiments. However, the drawings shall not be interpreted as defining or limiting the scope or nature covered by the embodiments. For example, the relative sizes, thicknesses, and locations of the layers, regions, and/or structures may be reduced or enlarged for clarity.

A structure (or layer, element, substrate) described in this disclosure is located on/above another structure (or layer, element, substrate), may indicate that the two structures are adjacent and directly connected, or may indicate that the two structures are adjacent but not directly connected. Indirect connection means that there is at least one intermediate structure (or intermediate layer, intermediate element, intermediate substrate, intermediate spacer) between the two structures, the lower surface of one structure is adjacent to or directly connected to the upper surface of the intermediate structure, and the upper surface of another structure is adjacent to or directly connected to the lower surface of the intermediate structure. The intermediate structure may be composed of a single-layer or multi-layer physical structure or a non-physical structure, which is not limited thereto. In the disclosure, when a certain structure is disposed "on" other structures, it may mean that a certain structure is "directly" on other structures, or it means that a certain structure is "indirectly" on other structures, that is, at least one structure is sandwiched between a certain structure and other structures.

The terms "about", "equal to", "equal" or "same", "substantially" or "generally" are interpreted as within 20% of a given value or range, or interpreted as within 10%, 5%, 3%, 2%, 1%, or 0.5% of the given value or range. Furthermore, the terms "range from a first value to a second value", "range between a first value to a second value" mean that the range includes the first value, the second value, and other values in between.

The terms such as "first", "second", etc. used in the description and the patent claims are used to modify elements, which do not imply and represent that the (or these) elements have any previous ordinal numbers, and also does not represent the order of a certain element and another element, or the order of the manufacturing method. The use of these ordinal numbers is to only clearly distinguish an element with a certain name from another element with the same name. The same terms may not be used in the patent claims and the description, and accordingly, the first component in the description may be the second component in the patent claims.

The electrical connection or coupling described in the disclosure may refer to direct connection or indirect connection. In the case of a direct connection, the end points of two elements on a circuit directly connect to each other, or connect to each other through a conductive wire. In the case of indirect connection, a switch, a diode, a capacitor, an inductor, a resistor, other suitable elements, or a combination thereof, but not limited therein, is between the end points of two elements on a circuit.

In the disclosure, the thickness, length, and width may be measured by adopting a measurement method such as an optical microscope (OM), and the thickness or width may be measured from a cross-sectional image in an electronic microscope, but not limited thereto. In addition, any two values or directions used for comparison may have certain errors. Additionally, references to the terms "equal to," "equal," "same," "substantially," or "generally" throughout this disclosure generally mean within 10% of a given value or range. Furthermore, the terms "a given range is from a first value to a second value", "a given range is within a range from the first value to the second value", or "a given range is between the first value to the second value" means that the given range includes the first value, the second value, and other values in between. If a first direction is perpendicular to a second direction, an angle between the first direction and the second direction may be between 80 degrees and 100 degrees; if the first direction is parallel to the second direction, an angle between the first direction and the second direction may be between 0 degrees and 10 degrees.

It should be noted that, in the following embodiments, the features in several different embodiments may be replaced, reorganized, and mixed to complete other embodiments without departing from the spirit of the disclosure. As long as the features of the various embodiments do not violate the spirit of the disclosure or conflict with one another, they may be mixed and matched arbitrarily.

Unless otherwise defined, all terms (including technical and scientific terms) used herein have the same meaning as commonly understood by one of ordinary skill in the art to which this disclosure belongs. It is understood that these terms, such as those defined in commonly used dictionaries, should be interpreted as having meanings consistent with the relevant art and the background or context of the disclosure, and should not be interpreted in an idealized or overly formal manner, unless otherwise defined in the embodiments of the disclosure.

In the disclosure, an electronic device may include a packaging device, a semiconductor device, a display device, a backlight device, an antenna device, a sensing device or a splicing device, but is not limited thereto. The electronic device may be a bendable or flexible electronic device. The display device may be a non-self-luminous display device or a self-luminous display device. The display device may include, for example, liquid crystal, light emitting diode, fluorescence, phosphor, quantum dot (QD), other suitable display media, or a combination thereof. The antenna device may include, for example, a frequency selective surface (FSS), a radio frequency filter (RF-filter), a polarizer, a resonator, or an antenna, etc. The antenna may be a liquid crystal type antenna or a non-liquid crystal type antenna. The sensing device may be a sensing device for sensing capacitance, light, heat or ultrasonic waves, but not limited thereto. In the disclosure, an electronic device may include electronic elements, and the electronic elements may include passive elements and active elements, such as a capacitor, a resistor, an inductor, a diode, a transistor, and the like. The diode may include a light emitting diode or a photodiode. The light emitting diode may include, for example, an organic light emitting diode (OLED), a mini light emitting diode (mini LED), a micro light emitting diode (micro LED), or a quantum dot light emitting diode (quantum dot LED), but not limited thereto. The splicing device may be, for example, a display splicing device or an antenna splicing device, but not limited thereto. It should be noted that, the electronic device may be any arrangement and combination of the foregoing, but not limited thereto. In addition, the shape of the electronic device may be rectangular, circular, polygonal, a shape with curved edges, or other suitable shapes. The electronic device may have a peripheral system such as a driving system, a control system, a light source system, and the like to support a display device, an antenna device, a wearable device (e.g., including augmented reality or virtual reality), an in-vehicle device (e.g., including car windshields), or a splicing device.

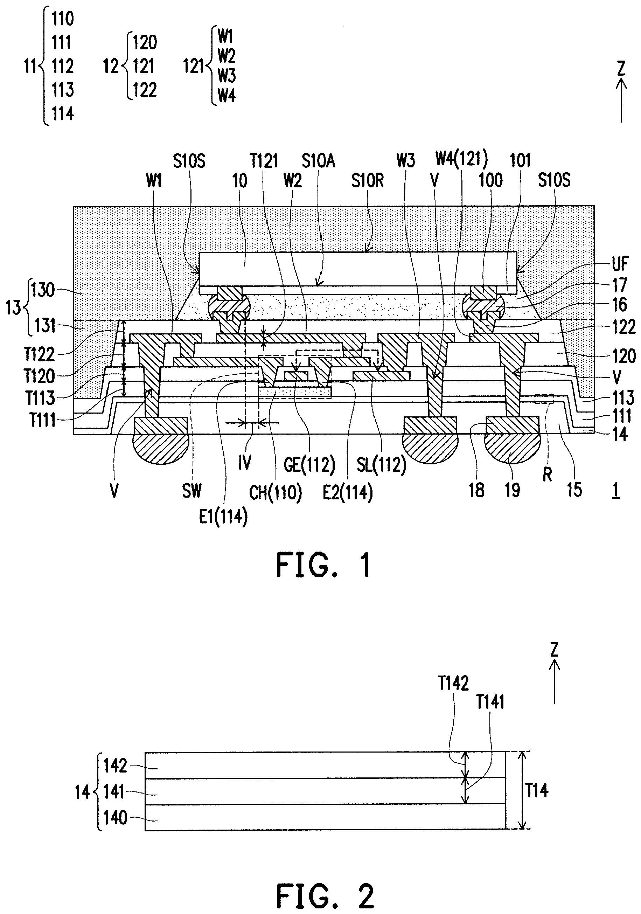

FIG. 1 is a cross-sectional schematic view of an electronic device according to a first embodiment of the disclosure. FIG. 2 is an enlarged view of region R in FIG. 1.

Referring to FIG. 1 first, an electronic device 1 may include a chip 10, an element structure layer 11, a redistribution structure layer 12, and a protective layer 13, but not limited thereto. The electronic device 1 may also include other elements or film layers according to different requirements. For example, the electronic device 1 may further include a buffer layer 14, an insulating layer 15, a conductive pad 16, a bonding pad 17, a conductive pad 18, a bonding pad 19, a via structure V, and an underfill UF.

In detail, the chip 10 may include integrated circuits, controllers, drivers, processors, memories, other functional elements or a combination of the above, and the chip 10 may be a system-on-chip (SoC), a system-on-integrated-circuit (SoIC), a diode, or a variable capacitor, but not limited thereto.

The chip 10 may have an active surface S10A, a rear surface S10R, and multiple side surfaces S10S. The rear surface S10R is opposite to the active surface S10A, and the active surface S10A is, for example, located between the rear surface S10R and the redistribution structure layer 12, but not limited thereto. The side surfaces S10S are located between the rear surface S10R and the active surface S10A, and each of the side surfaces S10S connects the rear surface S10R with the active surface S10A.

The chip 10 may include multiple contacts 100 configured to electrically connecting with external elements. A plurality of contacts 100 are disposed on the active surface S10A and, for example, face the redistribution structure layer 12. The material of the contacts 100 may include metal such as copper, aluminum, titanium, nickel, or a combination thereof, but not limited thereto.

In some embodiments, the chip 10 may further include an insulating layer 101. The insulating layer 101 is disposed on the active surface S10A and exposes multiple contacts 100. The material of the insulating layer 101 may include organic material, inorganic material, or a combination thereof. The organic material includes, for example, photosensitive polyimide (PSPI), polyolefin, soluble polyfluoroalkoxy (PFA), ajinomoto build-up film (ABF), epoxy resin, benzocyclobutene (BCB), polybenzoxazole (PBO), or a combination thereof, but not limited thereto. The inorganic material includes, for example, silicon oxide, silicon nitride, silicon oxynitride, or a combination thereof, but not limited thereto.

The element structure layer 11 is disposed adjacent to the active surface S10A. For example, the element structure layer 11 may include at least one first insulating layer (e.g., the insulating layer 111 and the insulating layer 113), at least one conductive layer (e.g., the conductive layer 112 and the conductive layer 114), and a semiconductor layer (e.g., the semiconductor layer 110), but not limited thereto. In some embodiments, the semiconductor layer 110, the insulating layer 111, the conductive layer 112, the insulating layer 113, and the conductive layer 114 are, for example, stacked sequentially between the buffer layer 14 and the redistribution structure layer 12 in the thickness direction (e.g., the direction Z) of the electronic device 1. The term "adjacent" referred to in the disclosure means that there is a shortest distance between a first element and a second element.

In detail, the semiconductor layer 110 is, for example, disposed on the buffer layer 14, and the material of the semiconductor layer 110 may include amorphous silicon, polysilicon, or metal oxide, such as indium gallium zinc oxide (IGZO), but not limited thereto. The semiconductor layer 110 is, for example, a patterned semiconductor layer, and the semiconductor layer 110 may include multiple semiconductor patterns CH (only one is schematically shown). According to some embodiments, the thickness of the semiconductor layer 110 is greater than or equal to 0.5 micrometers (µm) and less than or equal to 3 µm, but not limited thereto.

The insulating layer 111 is disposed on the semiconductor layer 110 and the buffer layer 14, and the material of the insulating layer 111 may include inorganic material such as silicon oxide, silicon nitride, silicon oxynitride or a combination thereof, but not limited thereto. According to some embodiments, the thickness of the insulating layer 111 is greater than or equal to 0.5 µm and less than or equal to 5 µm, but not limited thereto.

The conductive layer 112 is, for example, disposed on the insulating layer 111, and the material of the conductive layer 112 may include metal or a metal stack, such as aluminum, molybdenum, titanium, molybdenum/aluminum/molybdenum, or titanium/aluminum/titanium, but not limited thereto. The conductive layer 112 is, for example, a patterned conductive layer, and the conductive layer 112 may include multiple gates GE (only one is schematically shown), multiple scan lines SL (only one is schematically shown) and other lines (not shown), but not limited thereto. The gates GE respectively overlap the semiconductor patterns CH in the direction Z, and each gate GE is electrically connected to a corresponding scan line SL (the electrical connection is indicated by a dashed double arrow). According to some embodiments, the thickness of the insulating layer 111 is greater than or equal to 1 µm and less than or equal to 5 µm, but not limited thereto.

The insulating layer 113 is disposed on the insulating layer 111 and the conductive layer 112, and the material and thickness of the insulating layer 113 may refer to the material of the insulating layer 111, which is not repeated herein.

The conductive layer 114 is disposed on the insulating layer 113, and the material of the conductive layer 114 may include metal or a metal stack, such as aluminum, molybdenum, titanium, molybdenum/aluminum/molybdenum, or titanium/aluminum/titanium, but not limited thereto. The conductive layer 114 may be a patterned conductive layer, and the conductive layer 114 may include multiple first electrodes E1 (only one is schematically shown), multiple second electrodes E2 (only one is schematically shown), multiple data lines (not shown) and other lines (not shown), but not limited thereto. One of the first electrodes E1 and the second electrodes E2 is a source, and another one of the first electrodes E1 and the second electrodes E2 is a drain, in which each source is electrically connected to a corresponding data line. Each first electrode E1 and an adjacent second electrode E2 are respectively disposed on opposite sides of a corresponding semiconductor pattern CH, and each first electrodes E1 and second electrodes E2 penetrates the insulating layer 111 and the insulating layer 113 to be in contact with a corresponding semiconductor pattern CH.

The element structure layer 11 has a switch element SW. The switch element SW includes, for example, a semiconductor pattern CH, a gate GE, a first electrode E1, and a second electrode E2. The boundary or range of the switch element SW is, for example, defined by the edge of the semiconductor pattern CH. FIG. 1 schematically shows one switch element SW, but it should be understood that the electronic device 1 may include multiple switch elements SW, and the switch elements SW may be arranged in an array.

The redistribution layer 12 is disposed adjacent to the active surface S10A. For example, the redistribution structure layer 12 may include at least one second insulating layer (e.g., the insulating layer 120 and the insulating layer 122) and at least one conductive layer (e.g., the conductive layer 121). The at least one second insulating layer and the at least one conductive layer in the redistribution structure layer 12 are alternately stacked in the direction Z. According to some embodiments, the element structure layer 11 may be electrically connected to the chip 10 through the redistribution structure layer 12. For example, the redistribution structure layer 12 may realize the required electrical connection relationship of each component. According to some embodiments, the redistribution structure layer 12 may further increase the fan-out area of the conductive lines of the electronic device, but not limited thereto.

In detail, the insulating layer 120 is, for example, disposed on the insulating layer 113 and the conductive layer 114, and the material of the insulating layer 120 may include organic material, such as photosensitive polyimide, polyolefin, soluble polyfluoroalkoxy, ajinomoto build-up film, epoxy resin, benzocyclobutene, polybenzoxazole, or a combination thereof, but not limited thereto. According to some embodiments, the thickness T120 of the insulating layer 120 is greater than or equal to 5 µm and less than or equal to 25 µm, but not limited thereto. According to some embodiments, the thickness T120 of the insulating layer 120 may be greater than the thickness T111 of the insulating layer 111. Through the above design, the protection of the element structure layer 11 may be improved, thereby improving the reliability.

The conductive layer 121 is disposed on the insulating layer 120, and the material of the conductive layer 121 may include metal, such as copper, but not limited thereto. The conductive layer 121 may be a patterned conductive layer, and the conductive layer 121 may include multiple wires (e.g., wire W1, wire W2, wire W3, and wire W4). For example, the wire W1 penetrates the insulating layer 120 and is electrically connected to a corresponding first electrode E1. For example, the wire W2 penetrates the insulating layer 120 and is electrically connected to a corresponding second electrode E2. For example, the wire W3 penetrates the insulating layer 120 and the insulating layer 113, and is electrically connected to a corresponding scan line SL. According to some embodiments, the thickness T121 of the conductive layer 121 is greater than or equal to 5 µm and less than or equal to 25 µm, but not limited thereto. According to some embodiments, the thickness T121 of the conductive layer 121 may be greater than the thickness of the conductive layer 112.

The insulating layer 122 is disposed on the insulating layer 120 and the conductive layer 121, and the material of the insulating layer 122 may refer to the material of the insulating layer 120, which is not repeated herein.

In FIG. 1, at least one second insulating layer (e.g., the insulating layer 120 and the insulating layer 122) in the redistribution structure layer 12 is formed of organic material to provide a flat surface for carrying the conductive layer 121. Compared with the at least one first insulating layer (e.g., the insulating layer 111 and the insulating layer 113) formed of inorganic material in the element structure layer 11, the thickness of the at least one first insulating layer in the element structure layer 11 is, for example, less than the thickness of the at least one second insulating layer in the redistribution structure layer 12. Herein, the thickness of the film layer refers to the maximum thickness of the film layer on a plane in the thickness direction (e.g., the direction Z) of the electronic device 1 viewed from the cross-sectional view of the electronic device 1. In other words, the aforementioned "the thickness of the at least one first insulating layer in the element structure layer 11 is less than the thickness of the at least one second insulating layer in the redistribution structure layer 12" means that the maximum thickness of at least one of the insulating layer 111 and the insulating layer 113 in the direction Z (e.g., the thickness T111 or the thickness T113) is less than the maximum thickness of at least one of the insulating layer 120 and the insulating layer 122 in the direction Z (e.g., the thickness T120 or the thickness T122).

The conductive pad 16 is disposed on the insulating layer 122, and the material of the conductive pad 16 may include metal, such as copper, titanium, nickel, tin, silver, gold, or a combination thereof, but not limited thereto. FIG. 1 schematically shows two conductive pads 16, one of which penetrates the insulating layer 122 and is electrically connected to the wire W2, and the other conductive pad 16 penetrates the insulating layer 122 and is electrically connected to the wire W4. However, it should be understood that the number of conductive pads 16 and their connection relationships with other film layers may be changed according to actual requirements.

The conductive pads 16 may be electrically connected to external elements, such as the contacts 100 of the chip 10 or other elements, such as active elements, passive elements, etc., through multiple bonding pads 17. The material of the bonding pads 17 may include metal such as tin, nickel, gold, copper, or a combination thereof, but not limited thereto. In some embodiments, as shown in FIG. 1, the redistribution structure layer 12 may be electrically connected to the chip 10 through the conductive pad 16, and the contact 100, and the switch element SW may be connected to the chip 10 through the redistribution structure layer 12, the conductive pad 16, and the contact 100.

In some embodiments, the conductive pads 16 do not overlap the semiconductor patterns CH in the direction Z, so as to reduce the probability of the semiconductor patterns CH being crushed when the conductive pads 16 are bonded to the contacts 100. According to some embodiments, in a direction perpendicular to the direction Z (e.g., the lateral direction in FIG. 1), there is an interval IV between the side of the conductive pad 16 and the side of the semiconductor pattern CH, and the interval IV is greater than 0 µm. According to some embodiments, the interval IV is greater than 5 µm. According to some embodiments, the interval IV is greater than 8 µm.

The protective layer 13 includes a first portion 130 and a second portion 131. The first portion 130 surrounds the chip 10, and the second portion 131 surrounds the element structure layer 11 and the redistribution structure layer 12. Herein, the first element surrounding the second element means that the second element is at least partially disposed within the first element, and the second element may or may not contact the side surface of the first element. In FIG. 1, the first portion 130, for example, contacts the side surface S10S of the chip 10, and the second portion 131, for example, contacts the element structure layer 11 and the redistribution structure layer 12, but the disclosure is not limited thereto. The material of the protective layer 13 may include organic material, such as epoxy molding compound (EMC), so as to reduce the influence of moisture. According to some embodiments, the protective layer 13 may further include filler particles, such as silicon oxide, aluminum oxide, or other suitable materials, but not limited thereto. The particle size of the filler particles is greater than or equal to 0.1 µm and less than or equal to 30 µm. According to some embodiments, a thermal expansion coefficient of the insulating layer 111 is less than a thermal expansion coefficient of the insulating layer 120, and a thermal expansion coefficient of the insulating layer 111 is less than a thermal expansion coefficient of the protective layer 13. Through the above design, the stress generated when the heterogeneous interface is combined may be alleviated, for example, the stress at the interface between organic materials and inorganic materials may be alleviated, and interface cracking may be reduced, but not limited thereto. According to some embodiments, the protective layer 13 may not contact the rear surface S10R, but not limited thereto.

In some embodiments, the first portion 130 and the second portion 131 of the protective layer 13 may be integrally formed, that is, the first portion 130 and the second portion 131 may be formed simultaneously, but not limited thereto. In other embodiments, the first portion 130 and the second portion 131 may be formed successively, and the first portion 130 and the second portion 131 may be formed of the same or different materials.

The buffer layer 14 is, for example, disposed between the insulating layer 15 and the element structure layer 11 to protect the semiconductor layer 110 or reduce the pollution from the metal layer (e.g., a copper layer) or the organic insulating layer to the semiconductor layer 110 in a high temperature manufacturing process. The material of the buffer layer 14 may include inorganic material, such as silicon oxide, silicon nitride, silicon oxynitride, or a combination thereof, but not limited thereto. The buffer layer 14 may be a single layer or multiple layers.

In some embodiments, as shown in FIG. 2, the buffer layer 14 may include a first sub-layer 140, a second sub-layer 141, and a third sub-layer 142 sequentially stacked in the direction Z. The material of the third sub-layer 142 is, for example, silicon oxide, and the materials of the first sub-layer 140 and the second sub-layer 141 may be selected from the same or different inorganic materials as the third sub-layer 142. Considering process cost, process time, and protection, the total thickness T14 of the buffer layer 14 is greater than or equal to 0.3 µm and less than or equal to 2µm, that is, 0.3 µm≦T14≦2 µm. In addition, the thickness T142 of the third sub-layer 142 is, for example, greater than the thickness T141 of the second sub-layer 141.

The insulating layer 15 is, for example, disposed on a side of the buffer layer 14 away from the element structure layer 11 and covers multiple conductive pads 18. The material of the insulating layer 15 may be an organic material to provide a flat carrying surface. For example, the material of the insulating layer 15 may include photosensitive polyimide, polyolefin, soluble polyfluoroalkoxy, ajinomoto build-up film, epoxy resin, benzocyclobutene, polybenzoxazole, or a combination thereof, but not limited thereto. The insulating layer 15 may be a single insulating layer or multiple insulating layers stacked along the direction Z, in which the thickness of a single insulating layer is greater than or equal to 5 µm and less than or equal to 25 µm, but not limited thereto.

The conductive pad 18 is disposed between the bonding pad 19 and the insulating layer 15, and the material of the conductive pad 18 may refer to the material of the conductive pad 16, which is not repeated herein.

In some embodiments, the conductive pads 18 do not overlap the semiconductor patterns CH in the direction Z, so as to reduce the probability of the semiconductor patterns CH being crushed when the conductive pads 18 are bonded to an external element (not shown). According to some embodiments, the conductive pad 18 may have a ground or floating potential. According to some embodiments, when the conductive pad 18 is at a dummy potential, it may further have a heat dissipation function.

The bonding pad 19 is connected to the conductive pad 18 to facilitate the electrical connection between the conductive pad 18 and an external element (not shown). The material of the bonding pad 19 may refer to the material of the bonding pad 17, thus details are not repeated herein. According to some embodiments, a maximum width of the bonding pad 19 is greater than a maximum width of the bonding pad 17. Furthermore, the ratio of the width of the bonding pad 19 to the width of the bonding pad 17 may be greater than or equal to 1.2 and less than or equal to 2. The measurement direction of the width is, for example, measured along a direction perpendicular to the direction Z. Through the above design, the bonding strength between the electronic device 1 and the external element may be improved. The external element referred to in the disclosure may be, for example, a printed circuit board (PCB) or other suitable elements, but not limited thereto.

The via structure V penetrates the insulating layer 120, the insulating layer 113, the insulating layer 111, the buffer layer 14, and the insulating layer 15 to electrically connect one of the wires (such as the wire W1, the wire W3, or the wire W4) to a corresponding conductive pad 18. FIG. 1 schematically shows three via structures V. The via structure V located on the left side of FIG. 1 electrically connects the wire W1 to a corresponding conductive pad 18. The wire W1 is electrically connected to the first electrode E1 of the switch element SW, and the second electrode E2 of the switch element SW is electrically connected to a contact 100 of the chip 10 through the wire W2, the conductive pad 16, and the bonding pad 17. In addition, the via structure V located in the middle of FIG. 1 electrically connects the wire W3 to another corresponding conductive pad 18. The wire W3 is electrically connected to the scan line SL, and the scan line SL is electrically connected to the gate GE of the switch element SW. In addition, the via structure V located on the right side of FIG. 1 electrically connects the wire W4 to another corresponding conductive pad 18. The wire W4 is electrically connected to another contact 100 of the chip 10 through the conductive pad 16 and the bonding pad 17. However, it should be understood that the number of via structures V and their connection relationships with other elements or film layers may be changed according to actual requirements.

The underfill UF is disposed between the chip 10 and the insulating layer 122 to protect the bonding pads 17 or improve the adhesion between the chip 10 and the conductive pads 16.

By integrating the element structure layer 11 and the redistribution structure layer 12 together, it facilitates integrating different elements (e.g., chips 10 with different functions) into the electronic device 1 so that the electronic device 1 may provide more functions. In addition, the first portion 130 of the protective layer 13 surrounds the chip 10 and the second portion 131 of the protective layer 13 surrounds the element structure layer 11 and the redistribution structure layer 12, which may improve protection (e.g., water and oxygen blocking or anti-scratching, etc.), thereby improving the overall reliability of the electronic device 1.

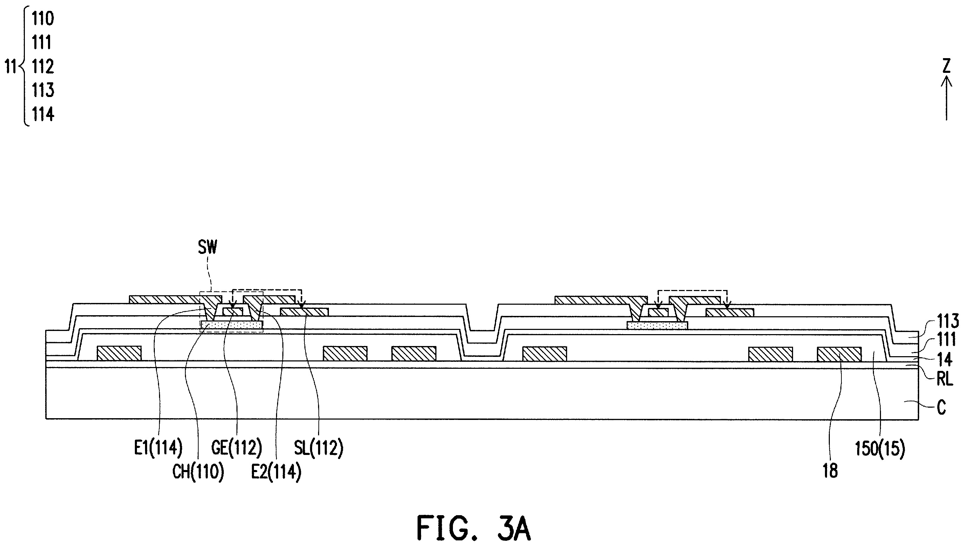

FIG. 3A to FIG. 3F are cross-sectional schematic views of the manufacturing process of the electronic device of the first embodiment. The manufacturing method for an electronic device 1 includes the following operation. An element structure layer 11 and a redistribution structure layer 12 are formed on a carrier C, in which the element structure layer 11 has a switch element SW. A chip 10 is disposed on the carrier. The chip 10 has an active surface S10A and multiple contacts 100 disposed on the active surface S10A, and the contacts 100 are electrically connected to the switch element SW and the redistribution structure layer 12. A protective layer 13 is formed on the carrier C, and the protective layer 13 includes a first portion 130 and a second portion 130. The first portion 130 surrounds the chip 10, and the second portion 131 surrounds the element structure layer 11 and the redistribution structure layer 12.

In some embodiments, as shown in FIG. 3A to FIG. 3F, the element structure layer 11 and the redistribution structure layer 12 may be formed on the carrier C first, followed by bonding the chip 10, and then forming the protective layer 13 (including the first portion 130 and second portion 131), but not limited thereto.

In detail, please refer to FIG. 3A, the method for manufacturing the electronic device 1 may include the following operation. A release layer RL, multiple conductive pads 18, an insulating layer 15, a buffer layer 14, and an element structure layer 11 are sequentially formed on the carrier C. The release layer RL may be a thermal dissociation layer or a photodissociation layer, that is, the viscosity of the release layer RL is reduced due to heat or light, so that the carrier C is separated from the film layer or element disposed thereon. The insulating layer 15 may include one or more patterns 150 (two patterns 150 are schematically shown). The patterns 150 may be separated from each other and, for example, arranged in an array. Relevant contents (e.g., materials, relative disposition relationships, etc.) of the conductive pads 18, the insulating layer 15, the buffer layer 14, and the element structure layer 11 may be referred to the above, and are not repeated herein.

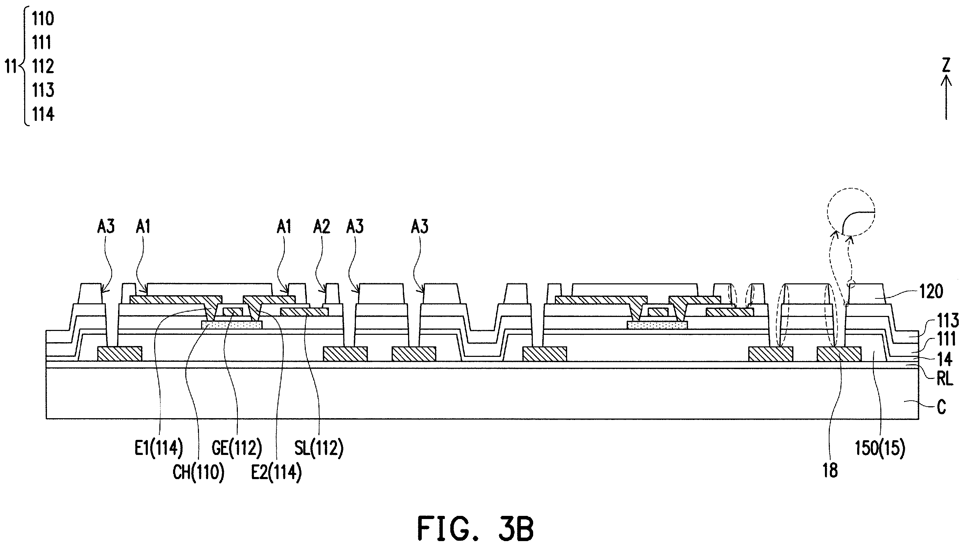

Referring to FIG. 3B, the manufacturing method of the electronic device 1 may further include the following operation. An insulating layer 120 is formed on the insulating layer 113 and the conductive layer 114. Multiple openings A1, multiple openings A2, and multiple openings A3 are formed. Each opening A1 penetrates the insulating layer 120 and exposes a portion of the first electrode E1 or a portion of the second electrode E2. Each opening A2 penetrates the insulating layer 120 and the insulating layer 113 and exposes a portion of the scan line SL. Each opening A3 penetrates the insulating layer 120, the insulating layer 113, the insulating layer 111, the buffer layer 14, and the insulating layer 15 and exposes a portion of the conductive pad 18.

In some embodiments, the aforementioned openings (e.g., the openings A1, the openings A2, and the openings A3) may be formed through one or more patterning processes. FIG. 3B schematically shows an aspect formed by two patterning processes. For example, the insulating layer 120 may be removed by a lithographic etching process first, and then the insulating layer 113, the insulating layer 111, the buffer layer 14, and the insulating layer 15 may be removed by a lithographic etching process or a laser process. In this way, the quality or process stability of the patterning process may be improved. Based on process considerations, the size of the openings formed by the first patterning process is, for example, larger than the size of the openings formed by the second patterning process, so that the openings formed by the two patterning processes (e.g., the openings A2 and the openings A3) has a stepped profile (see dashed box in FIG. 3B). According to some embodiments, the corner of at least one insulating layer at the opening may have an arc profile (see the enlarged view of FIG. 3B, which schematically shows that the corners of the insulating layer 120 and the insulating layer 113 have arc profiles), but not limited thereto. Through the arc profile design of the corner of the insulating layer at the opening, the risk of film cracking may be reduced.

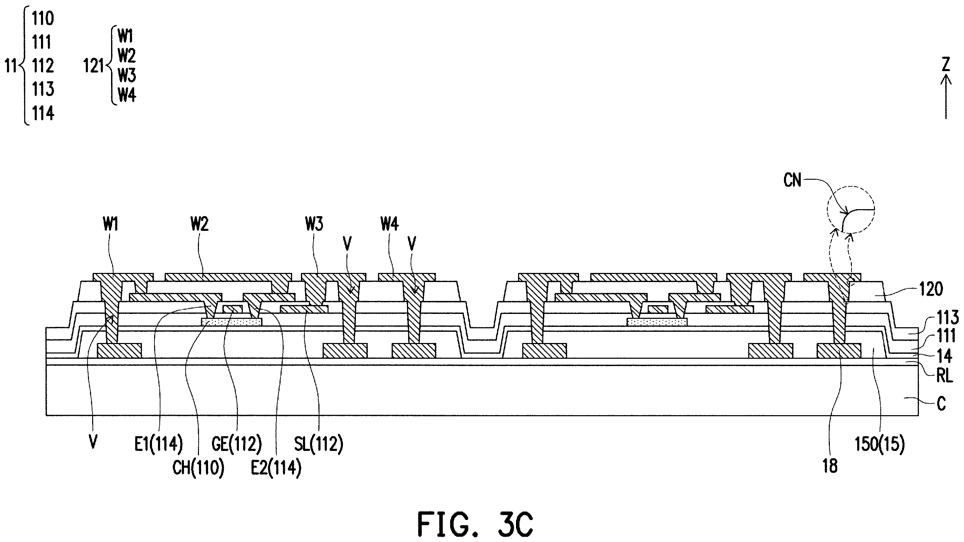

Referring to FIG. 3C, the manufacturing method of the electronic device 1 may further include the following operation. Conductive material is formed on the insulating layer 120 and in the aforementioned openings (e.g., the openings A1, the openings A2, and the openings A3 in FIG. 3B) to form the conductive layer 121 including multiple wires (e.g., the wire W1, the wire W2, the wire W3, and the wire W4) and multiple via structures V. The conductive layer 121 and the via structures V may have the same material and be formed simultaneously. In addition, the via structure V formed in the opening A3 of FIG. 3B may also have a stepped profile (see the elliptical dashed box in FIG. 3B). According to some embodiments, the corner CN of the via structure V may have an arc profile, which may further reduce the risk of insulating layer cracking, but not limited thereto.

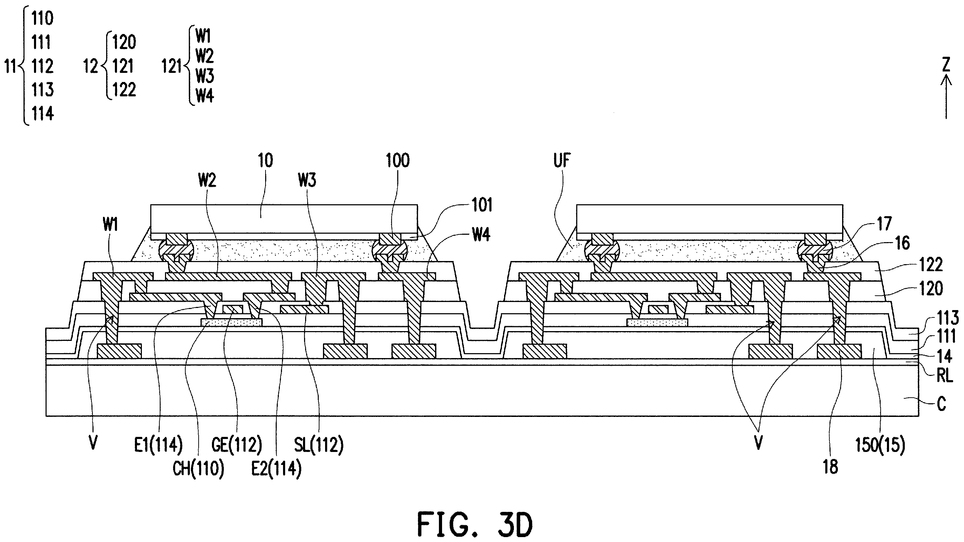

Referring to FIG. 3D, the manufacturing method of the electronic device 1 may further include the following operation. An insulating layer 122 and multiple conductive pads 16 are sequentially formed on the insulating layer 120 and the conductive layer 121. Then, multiple contacts 100 of multiple chips 10 are bonded to multiple conductive pads 16 through multiple bonding pads 17.

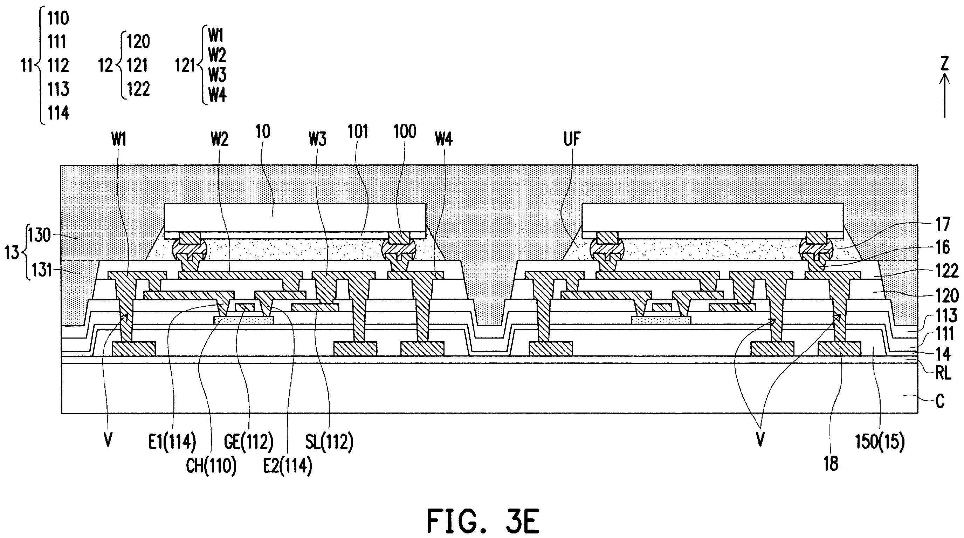

Referring to FIG. 3E, the manufacturing method of the electronic device 1 may further include forming a protective layer 13 on the carrier C. Relevant contents (e.g., materials, relative disposition relationships, etc.) of the protective layer 13 may be referred to the above, and are not repeated herein. In some embodiments, as shown in FIG. 3E, the first portion 130 and the second portion 131 of the protective layer 13 may be formed simultaneously and are integrally formed, but not limited thereto. In other embodiments, although not shown in FIG. 3E, the first portion 130 and the second portion 131 of the protective layer 13 may be formed successively, and the materials of the first portion 130 and the second portion 131 may be the same or different.

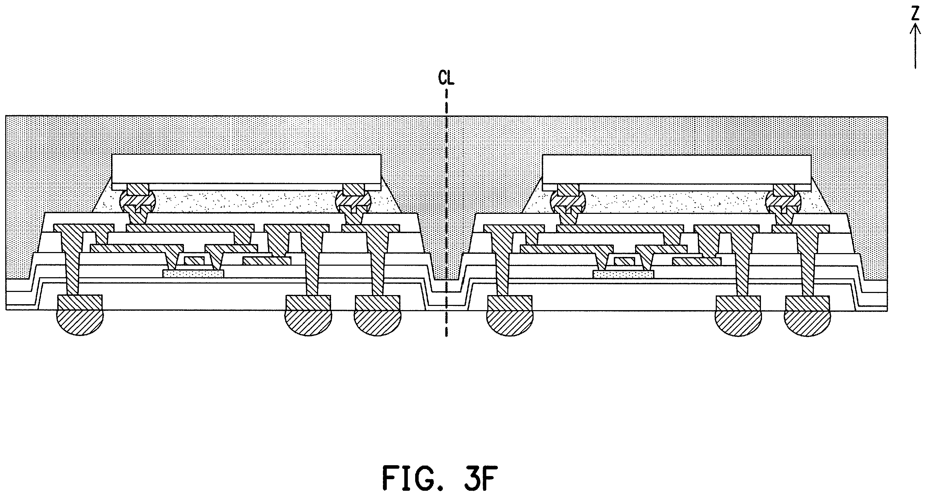

Referring to FIG. 3E and FIG. 3F, the manufacturing method of the electronic device 1 may further include the following operation. The carrier C is removed, for example, the viscosity of the release layer RL may be reduced by heating or lighting processes, so that the carrier C is separated from the film layers or elements (e.g., the conductive pads 18 and the insulating layer 15) disposed thereon.

In an embodiment where the insulating layer 15 includes multiple patterns 150, a cutting process may be performed. For example, cutting is performed along the cutting line CL in FIG. 3F to form multiple (two are schematically shown) electronic devices 1 as shown in FIG. 1.

Through the design that the organic insulating layers (e.g., the insulating layer 120, the insulating layer 122, and the insulating layer 15) under the adjacent chip 10 are separated from each other, the negative influence (e.g., wear) of the organic insulating layer on the cutting equipment (e.g., a knife) may be improved or the service life of the cutting equipment may be extended.

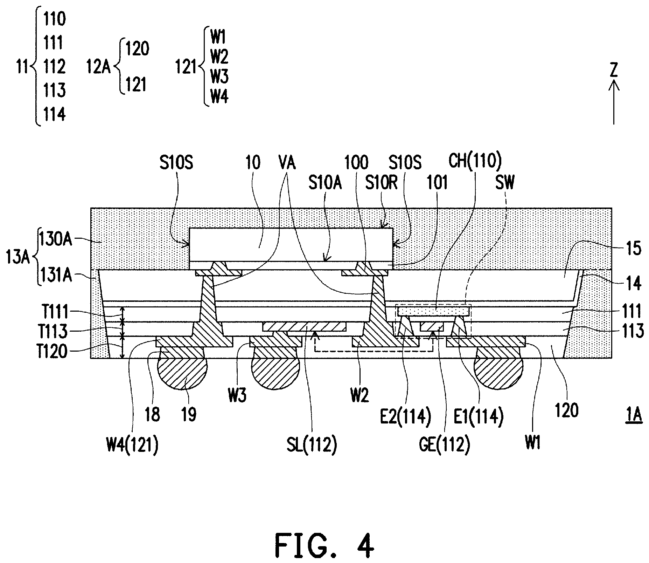

FIG. 4 is a cross-sectional schematic view of an electronic device according to a second embodiment of the disclosure. Referring to FIG. 4, the main differences between the electronic device 1A and the electronic device 1 of FIG. 1 are described as follows.

In the electronic device 1 of FIG. 1, an insulating layer 15, a buffer layer 14, an element structure layer 11, a redistribution structure layer 12, multiple conductive pads 16, and multiple bonding pads 17 are sequentially disposed from the conductive pads 18 to the chip 10. The wire W1 penetrates the insulating layer 120 and is electrically connected to the first electrode E1, and the wire W1 is electrically connected to a corresponding conductive pad 18 through a via structure V. The wire W2 penetrates the insulating layer 120 and is electrically connected to the second electrode E2, and a conductive pad 16 penetrates the insulating layer 122 and is electrically connected to the wire W2. The wire W3 penetrates the insulating layer 120 and the insulating layer 113 and is electrically connected to the scan line SL, and the wire W3 is electrically connected to another conductive pad 18 through another via structure V. The wire W4 is electrically connected to yet another conductive pad 18 through yet another via structure V. The via structure V penetrates the insulating layer 120, the insulating layer 113, the insulating layer 111, the buffer layer 14, and the insulating layer 15. The first portion 130 and the second portion 131 of the protective layer 13 are, for example, integrally formed.

On the other hand, in the electronic device 1A, the electronic device 1A may not include the conductive pads 16 and the bonding pads 17 of FIG. 1. The insulating layer 15, the buffer layer 14, the element structure layer 11 and the redistribution structure layer 12A are sequentially disposed from the chip 10 to the conductive pads 18. The redistribution structure layer 12A may not include the insulating layer 122 of FIG. 1. The wire W1 is disposed on the surface of the insulating layer 113 away from the chip 10 and connects the first electrode E1 to a corresponding conductive pad 18. The wire W2 is disposed on the surface of the insulating layer 113 away from the chip 10 and connected to the second electrode E2, and the wire W2 is electrically connected to a contact 100 through a via structure VA. The wire W3 is disposed on the surface of the insulating layer 113 away from the chip 10 and penetrates through the insulating layer 113 to be electrically connected to the scan line SL. The wire W4 is electrically connected to another contact 100 through another via structure VA. The via structure VA penetrates the insulating layer 113, the insulating layer 111, the buffer layer 14, and the insulating layer 15. According to some embodiments, a portion of the buffer layer 14 is located between the first portion 130A and the second portion 131A. In detail, the first portion 130A and the second portion 131A of the protective layer 13A are not integrally formed, and a portion of the buffer layer 14 is located between the first portion 130A and the second portion 131A.

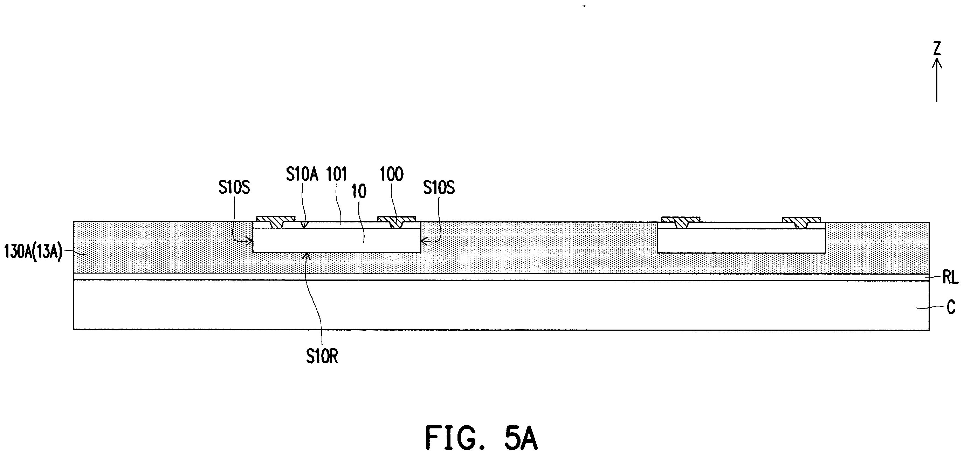

FIG. 5A to FIG. 5E are cross-sectional schematic views of the manufacturing process of the electronic device of the second embodiment. The main differences between the manufacturing process of FIG. 5A to FIG. 5E and the manufacturing process of FIG. 3A to FIG. 3F are described as follows.

In the manufacturing process of FIG. 3A to FIG. 3F, the conductive pads 18, the insulating layer 15, the buffer layer 14, the element structure layer 11, and the redistribution structure layer 12 are sequentially formed on the carrier C, followed by bonding the chips 10, and then forming the protective layer 13 and the bonding pads 19, in which the first portion 130 and the second portion 131 of the protective layer 13 may be formed simultaneously.

On the other hand, in the manufacturing process of FIG. 5A to FIG. 5E, the first portion 130A of the protective layer 13A and the chips 10 are formed on the carrier C first, followed by sequentially forming the insulating layer 15, the buffer layer 14, the element structure layer 11, the redistribution structure layer 12A, the second portion 131A of the protective layer 13A, and the bonding pads 19. In other words, the first portion 130A and the second portion 131A of the protective layer 13A are formed successively, in which the first portion 130A is formed before forming the element structure layer 11 and the redistribution structure layer 12A, and the second portion 131A is formed after forming the element structure layer 11 and the redistribution structure layer 12A.

In detail, referring to FIG. 5A, the manufacturing method of an electronic device 1A may include the following operation. A release layer RL, a first portion 130A of a protective layer 13A, and multiple chips 10 are formed on a carrier C. The rear surface S10R of the chip 10 is located between the active surface S10A of the chip 10 and the carrier C, and the first portion 130A of the protective layer 13A surrounds the sidewalls S10S of the chips 10 and exposes the contacts 100.

In some embodiments, the forming method of the architecture of FIG. 5A may include the following operation. The chips 10 not formed with multiple contacts 100 are placed on another carrier (not shown) formed with a release layer (not shown), and the active surface S10A is located between the rear surface S10R and the other carrier. A first portion 130A of a protective layer 13A is formed on the other carrier to cover multiple chips 10. The entire structure is inverted on the carrier C formed with the release layer RL and the other carrier is removed. Multiple contacts 100 are formed. Alternatively, the forming method of the architecture of FIG. 5A may include the following operation. The chips 10 not formed with multiple contacts 100 are placed on the carrier C formed with the release layer RL, and the rear side S10R is located between the active side S10A and the carrier C. A first portion 130A of a protective layer 13A is formed on the carrier C to cover multiple chips 10. A polishing process is performed to expose the insulating layer 101. Multiple contacts 100 are formed.

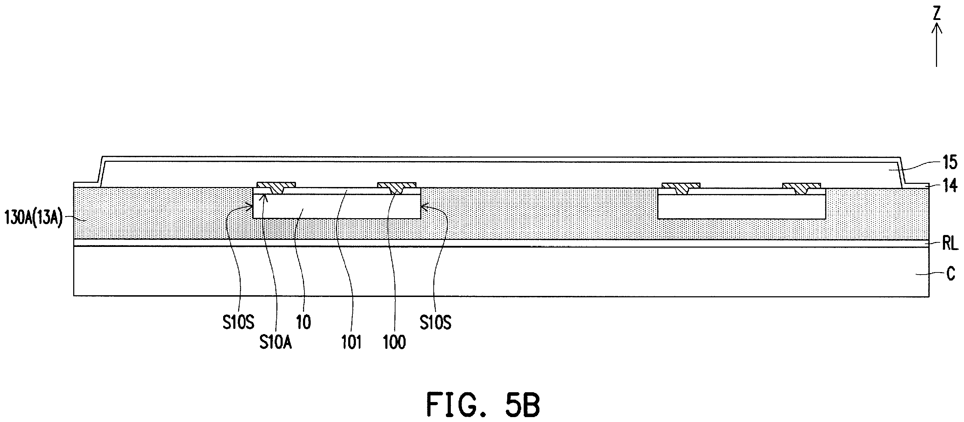

Referring to FIG. 5B, the manufacturing method of the electronic device 1A may further include sequentially forming the insulating layer 15 and the buffer layer 14 on the first portion 130A and the chips 10.

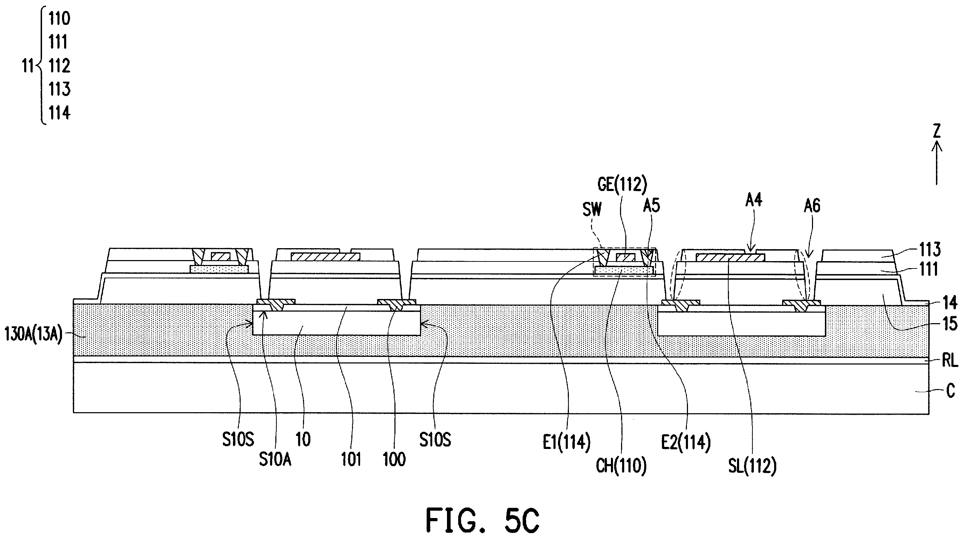

Referring to FIG. 5C, the manufacturing method of the electronic device 1A may further include sequentially forming a semiconductor layer 110, an insulating layer 111, a conductive layer 112, and an insulating layer 113 on the buffer layer 14.

The manufacturing method of the electronic device 1A may further include the following operation. Multiple openings A4, multiple openings A5, and multiple openings A6 are formed. Each opening A4 penetrates the insulating layer 113 and exposes a portion of the scan line SL. Each opening A5 penetrates the insulating layer 113 and the insulating layer 111 and exposes a portion of the semiconductor pattern CH. Each opening A6 penetrates the insulating layer 113, the insulating layer 111, the buffer layer 14, and the insulating layer 15 and exposes a portion of the contact 100. The forming method of the openings A4, the openings A5, and the openings A6 may refer to the forming method of the openings A1, the openings A2, and the opening A3, and details are not repeated herein.

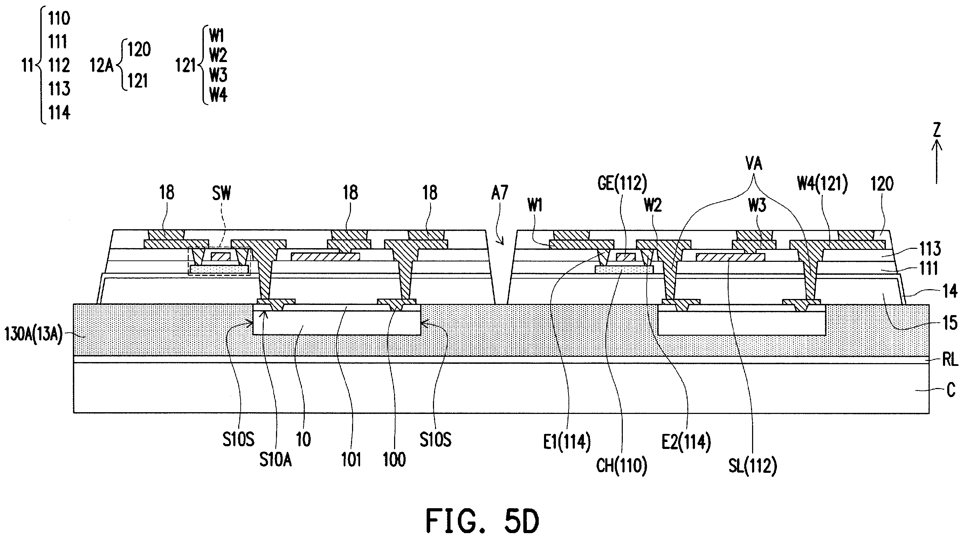

According to some embodiments, although not shown in FIG. 5C, the edge of the buffer layer 14 may retract by a distance from the edge of the carrier C by patterning the buffer layer 14 through a lithographic etching process, a laser process, or a combination of the above. According to some embodiments, the aforementioned step of patterning the buffer layer 14 may be performed together with the step of forming the aforementioned openings (e.g., the openings A4, the openings A5, and the openings A6) or before or after the step of forming the aforementioned openings (e.g., performed simultaneously with the formation of the opening A7 of FIG. 5D). Alternatively, the step of patterning the buffer layer 14 may be omitted.

The manufacturing method of the electronic device 1A may further include filling the openings A5 with conductive material to form the first electrode E1 and the second electrode E2.

Referring to FIG. 5D, the manufacturing method of the electronic device 1A may further include the following operation. Conductive material is formed on the insulating layer 113 and in the openings A1, the openings A2, and the openings A3 to form the conductive layer 121 including multiple wires (e.g., the wire W1, the wire W2, the wire W3, and the wire W4) and multiple via structures VA. The conductive layer 121 and the via structures VA may have the same material and be formed simultaneously. In addition, the via structure VA formed in the opening A6 of FIG. 5C may also have a stepped profile (see the dashed box in FIG. 5C).

The manufacturing method of the electronic device 1A may further include the following operation. An insulating layer 120 and multiple conductive pads 18 are sequentially formed on the insulating layer 113 and the conductive layer 121. Each conductive pad 18 penetrates the insulating layer 120 and is electrically connected to a corresponding wire W1, a corresponding wire W3, or a corresponding wire W4.

The manufacturing method of the electronic device 1A may further include forming an opening A7 penetrating the insulating layer 120, the insulating layer 113, the insulating layer 111, the buffer layer 14, and the insulating layer 15 between two adjacent chips 10. The opening A7 may be formed through one or more patterning processes. For example, the opening A7 may be formed through a lithographic etching process, a laser process, or a combination thereof, but not limited thereto. According to some embodiments, as mentioned above, the edge of the buffer layer 14 may retract by a distance from the edge of the carrier C by patterning the buffer layer 14 through a lithographic etching process, a laser process, or a combination of the above.

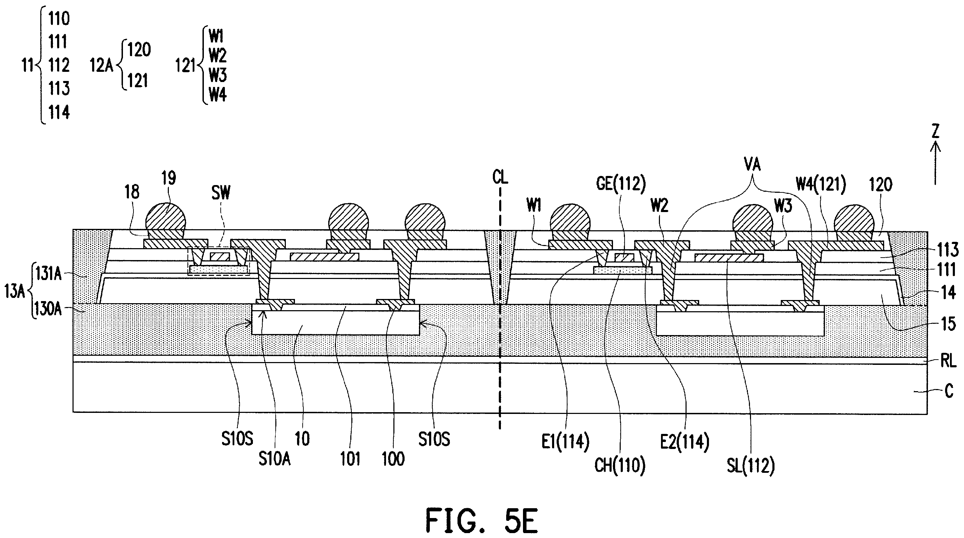

Referring to FIG. 5E, the manufacturing method of the electronic device 1A may further include the following operation. A second portion 131A of the protective layer 13A is formed. The second portion 131A fills the opening A7 in FIG. 5D and surrounds the element structure layer 11, the redistribution structure layer 12A, and the buffer layer 14. Multiple bonding pads 19 are formed on the conductive pads 18. In detail, in the normal direction (direction Z) of the electronic device 1, a portion of the buffer layer 14 is located between the first portion 130A and the second portion 131A. The impact of water and oxygen on the electronic device may be blocked through the above design, but not limited thereto.

The manufacturing method of the electronic device 1 may further include performing a cutting process. For example, cutting is performed along the cutting line CL in FIG. 5E to form multiple (two are schematically shown) electronic device 1A as shown in FIG. 4.

Through the design that the organic insulating layers (e.g., the insulating layer 120 and the insulating layer 15) under the adjacent chip 10 are separated from each other, the negative influence (e.g., wear) of the organic insulating layer on the cutting equipment (e.g., a knife) may be improved or the service life of the cutting equipment may be extended.

Although the aforementioned embodiment, for example, disconnects the organic insulating layers (e.g., the insulating layer 120 and the insulating layer 15) above the adjacent chip 10 after forming the conductive pads 18, the disclosure is not limited thereto. For example, after the insulating layer 15 is formed, a patterning process may be performed on the insulating layer 15 to form multiple patterns 150 as shown in FIG. 3A.

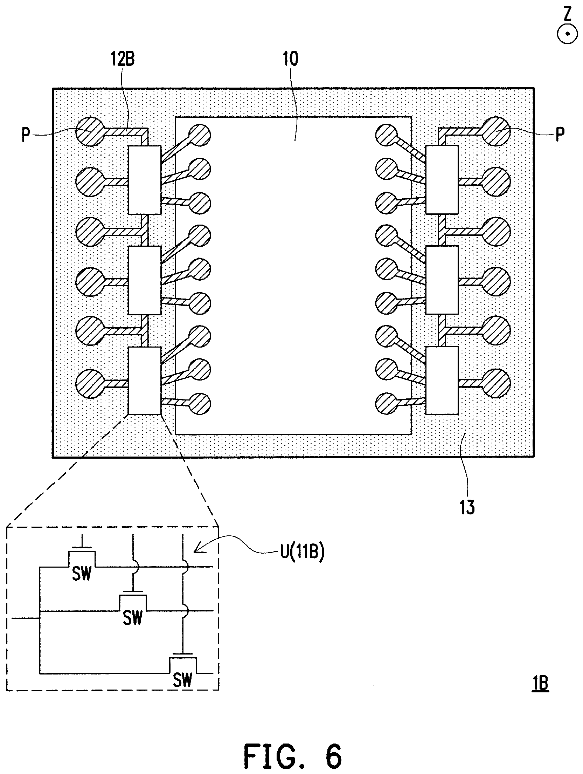

FIG. 6 is a top schematic view of an electronic device according to a third embodiment of the disclosure. Referring to FIG. 6, an electronic device 1B may include a chip 10, an element structure layer 11B, a redistribution structure layer 12B, and a protective layer 13, but not limited thereto. The element structure layer 11B may include multiple demultiplexers (DEMUX) U to reduce the number of I/O pins P or to release space. Each demultiplexer U may include multiple switch elements SW (three are schematically shown in FIG. 6, but not limited thereto).

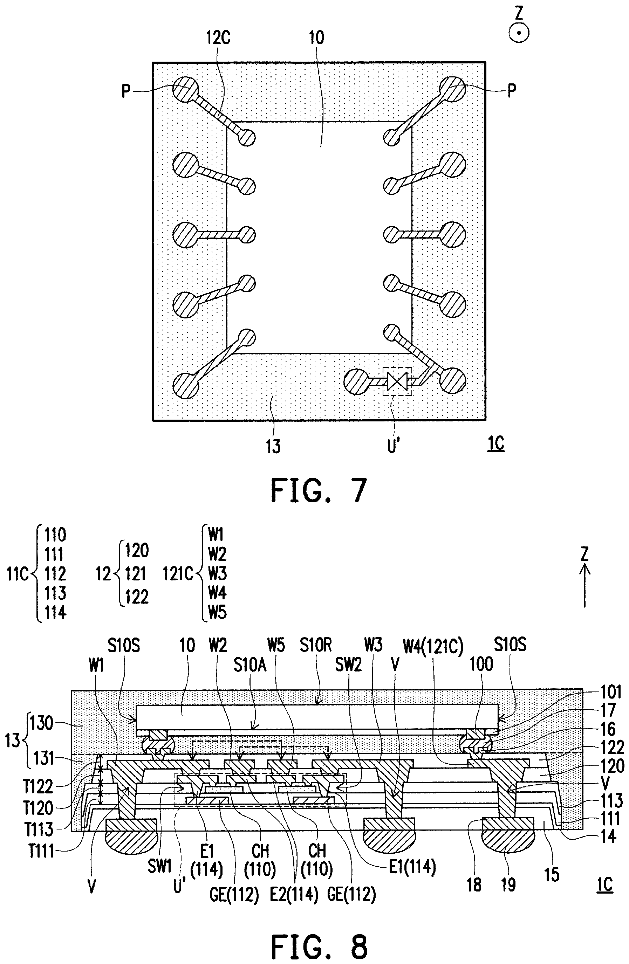

FIG. 7 and FIG. 8 are respectively a top schematic view and a cross-sectional schematic view of an electronic device according to a fourth embodiment of the disclosure. Referring to FIG. 7, the main differences between the electronic device 1C and the electronic device 1 of FIG. 1 are described as follows.

In the element structure layer 11C of the electronic device 1C, the positions of the semiconductor layer 110 and the conductive layer 112 are reversed. In addition, the element structure layer 11C includes a switch element SW1 and a switch element SW2, and the switch element SW1 and the switch element SW2 form an electrostatic discharge (ESD) protection unit. The first electrode E1 of the switch element SW1 penetrates the insulating layer 113 and is electrically connected to the semiconductor pattern CH of the switch element SW1, and the first electrode E1 further penetrates the insulating layer 113 and the insulating layer 111 to be electrically connected to the gate GE of the switch element SW1. Similarly, the first electrode E1 of the switch element SW2 penetrates the insulating layer 113 and is electrically connected to the semiconductor pattern CH of the switch element SW1, and the first electrode E1 further penetrates the insulating layer 113 and the insulating layer 111 to be electrically connected to the gate GE of the switch element SW2.

In the electronic device 1C, the conductive layer 121C includes a wire W1, a wire W2, a wire W3, a wire W4, and a wire W5. The wire W1 penetrates the insulating layer 120 and is electrically connected to the first electrode E1 of the switch element SW1, and the wire W1 is electrically connected to a conductive pad 18 through a via structure V. In addition, the wire W1 is also electrically connected to the wire W5. The wire W2 penetrates the insulating layer 120 and is electrically connected to the second electrode E2 of the switch element SW1, and the wire W2 is also electrically connected to the wire W3. The wire W5 penetrates the insulating layer 120 and is electrically connected to the second electrode E2 of the switch element SW2. The wire W3 penetrates the insulating layer 120 and is electrically connected to the first electrode E1 of the switch element SW2, and the wire W3 is electrically connected to another conductive pad 18 through another via structure V. The wire W4 is electrically connected to yet another conductive pad 18 through yet another via structure V.

In the electronic device 1C, the protective layer 13 may surround the element structure layer 11, the redistribution structure layer 12, the buffer layer 14, and the insulating layer 15 by patterning the element structure layer 11, the redistribution structure layer 12, the buffer layer 14, and the insulating layer 15 through a lithographic etching process, a laser process, other suitable processes, or a combination of the above.

In summary, in the embodiments of the disclosure, by integrating the element structure layer and the redistribution structure layer together, it facilitates integrating different elements (e.g., chips with different functions) into the electronic device so that the electronic device may provide more functions. In addition, the first portion of the protective layer surrounds the chip and the second portion of the protective layer surrounds the element structure layer and the redistribution structure layer, which may improve protection (e.g., water and oxygen blocking or anti-scratching, etc.), thereby improving the overall reliability of the electronic device.

Although the embodiments of the disclosure and the advantages thereof have been disclosed above, it should be understood that any person with ordinary skill in the art may make changes, substitutions, and modifications without departing from the spirit and scope of the disclosure, and the features of the various embodiments may be arbitrarily mixed and replaced with one another to form other new embodiments. In addition, the protection scope of the disclosure is not limited to the processes, machines, manufactures, compositions of the matter, devices, methods, and steps in the specific embodiments described in the specification. It is understood that processes, machines, manufactures, compositions of matter, devices, methods, and steps developed in the present or in the future may be used in accordance with the disclosure as long as they may implement substantially the same functions or achieve substantially the same results in the embodiments described herein. Therefore, the protection scope of the disclosure includes the above-mentioned processes, machines, manufactures, compositions of matter, devices, methods, and steps. In addition, each of the claims constitutes a separate embodiment, and the protection scope of the disclosure also includes each of the combinations of the claims and the embodiments. The protection scope of the disclosure shall be determined by the appended patent claims.

## Claims

1. An electronic device (1, 1A, 1C), comprising:
a chip (10) having an active surface (S10A) and a plurality of contacts (100) disposed on the active surface (S10A);
an element structure layer (11, 11C) disposed adjacent to the active surface (S10A) and having a switch element (SW), wherein the switch element (SW) is electrically connected to the chip (10) through at least one of the contacts (100);
a redistribution structure layer (12, 12A) disposed adjacent to the active surface (S10A) and electrically connected to the chip (10) through at least one of the contacts (100); and
a protective layer (13, 13A) comprising a first portion (130, 130A) and a second portion (131, 131A), wherein the first portion (130, 130A) surrounds the chip (10), and the second portion (131, 131A) surrounds the element structure layer (11, 11C) and the redistribution structure layer (12, 12A).

2. The electronic device (1, 1A, 1C) according to claim 1, wherein the first portion (130, 130A) contacts a side surface (S10S) of the chip (10), and the second portion (131, 131A) contacts the element structure layer (11, 11C) and the redistribution structure layer (12, 12A).

3. The electronic device (1, 1A, 1C) according to claim 1 or 2, wherein the element structure layer (11, 11C) comprises at least one first insulating layer (111, 113), the redistribution structure layer (12, 12A) comprises at least one second insulating layer (120, 122), and a thickness (T111, T113) of the at least one first insulating layer (111, 113) is less than a thickness (T120, T122) of the at least one second insulating layer (120, 122).

4. The electronic device (1, 1A, 1C) according to claim 3, wherein the at least one first insulating layer (111, 113) comprises an inorganic material, and the at least one second insulating layer (120, 122) comprises an organic material.

5. The electronic device (1, 1A, 1C) according to claim 3 or 4, further comprising:
a via structure (V, VA) penetrating the at least one first insulating layer (111, 113) and the at least one second insulating layer (120).

6. The electronic device (1, 1A, 1C) according to claim 5, wherein the via structure (V, VA) has a stepped profile.

7. The electronic device (1, 1A, 1C) according to any one of claims 1 to 6, further comprising:
a buffer layer (14), wherein the element structure layer (11, 11C) is disposed between the buffer layer (14) and the redistribution structure layer (12, 12A); and
an insulating layer (15), wherein the buffer layer (14) is disposed between the insulating layer (15) and the element structure layer (11, 11C).

8. The electronic device (1, 1A, 1C) according to claim 7, wherein the buffer layer (14) comprises an inorganic material.

9. The electronic device (1, 1A, 1C) according to claim 7 or 8, wherein the insulating layer (15) comprises an organic material.

10. The electronic device (1, 1C) according to any one of claims 7 to 9, wherein the element structure layer (11, 11C), the redistribution structure layer (12), and the buffer layer (14) are disposed between the chip (10) and the insulating layer (15).

11. The electronic device (1A) according to any one of claims 7 to 9, wherein the element structure layer (11), the buffer layer (14), and the insulating layer (15) are disposed between the chip (10) and the redistribution structure layer (12A).

12. The electronic device (1, 1C) according to any one of claims 1 to 10, further comprising:
an underfill (UF) disposed between the chip (10) and the redistribution structure layer (11, 11C), wherein the first portion (130) further surrounds the underfill (UF).

13. A manufacturing method of an electronic device (1, 1A, 1C), comprising:
forming an element structure layer (11, 11C) and a redistribution structure layer (12, 12A) on a carrier (C), wherein the element structure layer (11, 11C) has a switch element (SW);
disposing a chip (10) on the carrier (C), wherein the chip (10) has an active surface (S10A) and a plurality of contacts (100) disposed on the active surface (S10A), and the contacts (100) are electrically connected to the switch element (SW) and the redistribution structure layer (12, 12A); and
forming a protective layer (13, 13A) on the carrier (C), the protective layer (13, 13A) comprising a first portion (130, 130A) and a second portion (131, 131A), wherein the first portion (130, 130A) surrounds the chip (10), and the second portion (131, 131A) surrounds the element structure layer (11, 11C) and the redistribution structure layer (12, 12A).

14. The manufacturing method of the electronic device (1A) according to claim 13, wherein the first portion (130A) is formed before forming the element structure layer (11) and the redistribution structure layer (12A), and the second portion (131A) is formed after forming the element structure layer (11) and the redistribution structure layer (12A).

15. The manufacturing method of the electronic device (1A) according to claim 14, further comprising:
sequentially forming an insulating layer (15) and a buffer layer (14) on the carrier (C) before forming the element structure layer (11) and the redistribution structure layer (12A), wherein a portion of the buffer layer (14) is located between the first portion (130A) and the second portion (131A).
